# EUROPÄISCHE PATENTANMELDUNG

(11) **EP 3 672 007 A1**
(43) Veröffentlichungstag der Anmeldung: **24.06.2020**
(21) Anmeldenummer: 18213067.4
(22) Anmeldetag: 17.12.2018
(51) Int. Cl.: H02H 5/04, H02H 7/12, H02M 1/32

(54) **ERMITTLUNG DER FLIESSGESCHWINDIGKEIT IN EINEM KÜHLMITTELKREISLAUF**

(71) Anmelder: Siemens Aktiengesellschaft, 80333 München (DE)
(72) Erfinder: Hoffmann, Ingolf, 91074 Herzogenaurach (DE); Geyer, Horst, 91058 Erlangen (DE); Chahid, Abderrahim, 91334 Hemhofen (DE)

(57) **Zusammenfassung**

Eine Umsetzeinrichtung (1), welche eine Eingangsleistung (Pin) in eine Ausgangsleistung (Pout) umsetzt und hierbei eine Verlustleistung (δP) bewirkt, wird mittels eines Kühlmittelkreislaufes (3) gekühlt, in dem ein Kühlmittel (8) fließt. Eine Überwachungseinrichtung (9) der Umsetzeinrichtung (1) ermittelt anhand von Betriebsdaten (TV, TL, δP) der Umsetzeinrichtung (1) und/oder des Kühlmittelkreislaufes (3) eine Fließgeschwindigkeit (v), mit welcher das Kühlmittel (8) in dem Kühlmittelkreislauf (3) fließt. Die Überwachungseinrichtung (9) vergleicht die ermittelte Fließgeschwindigkeit (v) mit einer Grenzgeschwindigkeit (vG). Wenn die Fließgeschwindigkeit (v) die Grenzgeschwindigkeit (vG) erreicht oder überschreitet, ergreift die Überwachungseinrichtung (9) eine Sonderreaktion. Solange die Fließgeschwindigkeit (v) die Grenzgeschwindigkeit (vG) nicht erreicht, ergreift die Überwachungseinrichtung (9) entweder gar keine Reaktion oder eine von der Sonderaktion verschiedene Normalreaktion.

## Beschreibung

Die vorliegende Erfindung geht aus von einem Überwachungsverfahren für einen Kühlmittelkreislauf, in dem ein Kühlmittel fließt, mittels dessen eine eine Verlustleistung bewirkende Umsetzeinrichtung gekühlt wird.

Die vorliegende Erfindung geht weiterhin aus von einem Computerprogramm für eine Überwachungseinrichtung einer Umsetzeinrichtung, wobei das Computerprogramm Maschinencode umfasst, der von der Überwachungseinrichtung unmittelbar abarbeitbar ist, wobei die Abarbeitung des Maschinencodes durch die Überwachungseinrichtung bewirkt, dass die Überwachungseinrichtung ein derartiges Überwachungsverfahren ausführt.

Die vorliegende Erfindung geht weiterhin aus von einer Überwachungseinrichtung einer Umsetzeinrichtung, wobei die Überwachungseinrichtung mit einem derartigen Computerprogramm programmiert ist, so dass die Überwachungseinrichtung ein derartiges Überwachungsverfahren ausführt.

Die vorliegende Erfindung geht weiterhin aus von einer Umsetzeinrichtung, mittels derer unter Bewirkung von Verlustleistung eine der Umsetzeinrichtung zugeführte Eingangsleistung in eine Ausgangsleistung umgesetzt wird, wobei die Umsetzeinrichtung einen Kühlmittelkreislauf aufweist, in dem ein Kühlmittel fließt, mittels dessen die Umsetzeinrichtung gekühlt wird, wobei die Umsetzeinrichtung eine derartige Überwachungseinrichtung aufweist, die im Betrieb ein derartiges Überwachungsverfahren ausführt.

Ein derartiges Überwachungsverfahren ist beispielsweise aus der DE 10 2006 018 771 A1 bekannt. Bei diesem Überwachungsverfahren wird eine Isttemperatur des Kühlmittels messtechnisch erfasst. Es werden weitere Größen erfasst und daraus ermittelt, ob die Umsetzeinrichtung hinreichend gekühlt wird. Ist dies nicht der Fall, wird - sofern möglich - der Kühlmittelstrom vergrößert, so dass eine ausreichende Kühlung erfolgt. Ist eine Vergrößerung des Kühlmittelstroms nicht mehr möglich, wird der Betriebszustand der Umsetzeinrichtung angepasst, so dass die Kühlung ausreicht.

In Umsetzeinrichtungen wird eine der Umsetzeinrichtung zugeführte Eingangsleistung in eine Ausgangsleistung umgesetzt. Beispiele derartiger Umsetzeinrichtungen sind eine Verbrennungskraftmaschine und ein Frequenzumrichter. Bei einer Verbrennungskraftmaschine wird in dem verwendeten Kraftstoff gespeicherte chemische Energie in mechanische Energie umgesetzt. Bei einem Frequenzumrichter wird elektrische Energie in andersartige elektrische Energie umgesetzt, beispielsweise von einer Gleichspannung in eine Wechselspannung oder umgekehrt. Auch eine Umsetzung von einer Wechselspannung einer Eingangsfrequenz in eine Wechselspannung einer Ausgangsfrequenz ist möglich. Die Ausgangsfrequenz ist in diesem Fall in der Regel von der Eingangsfrequenz verschieden.

In vielen Fällen fällt bei der Umsetzung der Eingangsleistung in die Ausgangsleistung in der Umsetzeinrichtung eine nennenswerte Verlustleistung an. Die Verlustleistung muss aus der Umsetzeinrichtung abgeführt werden.

In vielen Fällen weist die jeweilige Umsetzeinrichtung zum Abführen der Verlustleistung einen Kühlmittelkreislauf auf, mittels dessen die Umsetzeinrichtung gekühlt wird. Der Kühlmittelkreislauf soll möglichst robust und langlebig sein. Insbesondere soll der Kühlmittelkreislauf korrosionsbeständig sein. Die Korrosionsbeständigkeit wird in der Regel durch Wahl eines geeigneten Materials erreicht. Beispiele derartiger Materialien sind Aluminium, Edelstahl und Kupfer-Nickel-Eisen-Legierungen. Die Korrosionsbeständigkeit des jeweiligen Materials wird in der Regel durch eine dünne Oxidschicht erreicht, welche sich auf der Oberfläche des Materials bildet. Solange die Kühlflüssigkeit in dem Kühlmittelkreislauf mit einer Fließgeschwindigkeit fließt, die unterhalb einer vorbestimmten Geschwindigkeit liegt, arbeitet der Kühlmittelkreislauf ordnungsgemäß. Wenn die Fließgeschwindigkeit die vorbestimmte Geschwindigkeit jedoch überschreitet, kann die Oxidschicht durch Erosion oder Abrasion beschädigt werden. Dadurch verlieren die das Kühlmittel führenden Bauteile ihre Korrosionsbeständigkeit. Weiterhin können die kleinen erodierten oder abradierten Partikel der Oxidschicht wie Schmirgel wirken und dadurch zu weiteren Schäden führen, beispielsweise in einer Pumpe des Kühlmittelkreislaufes. Die vorbestimmte Geschwindigkeit hängt vom Material des Kühlmittelkreislaufes, der Geometrie des Kühlmittelkreislaufes und dem Kühlmittel ab, insbesondere von dessen chemischer Zusammensetzung, in manchen Fällen auch zusätzlich von dessen Temperatur.

Im Stand der Technik werden in den Produktbeschreibungen von Umsetzeinrichtungen oftmals der Arbeitspunkt der Kühlvorrichtung (in Volumenstrom und Nenndruck) und weiterhin der zulässige Maximaldruck angegeben. Weiterhin wird das Kühlmittel selbst (beispielsweise der Anteil an Wasser, Inhibitoren und Frostschutzmittel) angegeben. Diese Vorgehensweise führt nicht immer zum gewünschten Erfolg. Insbesondere werden bei konservativer Vorgehensweise zwar Schäden am Kühlmittelkreislauf vermieden, der potentielle Leistungsbereich der Umsetzeinrichtung kann aber nicht vollständig ausgenutzt werden. Wenn hingegen der potentielle Leistungsbereich der Umsetzeinrichtung ausgenutzt werden soll, besteht bei höheren Leistungen die Gefahr von Schäden des Kühlmittelkreislaufes.

Die Aufgabe der vorliegenden Erfindung besteht darin, Möglichkeiten zu schaffen, mittels derer der potentielle Leistungsbereich der Umsetzeinrichtung ausgenutzt werden kann, ohne Schäden am Kühlmittelkreislauf zu riskieren.

Die Aufgabe wird durch ein Überwachungsverfahren mit den Merkmalen des Anspruchs 1 gelöst. Vorteilhafte Ausgestaltungen des Überwachungsverfahrens sind Gegenstand der abhängigen Ansprüche 2 bis 6.

Erfindungsgemäß wird ein Überwachungsverfahren für einen Kühlmittelkreislauf geschaffen, wobei in dem Kühlmittelkreislauf ein Kühlmittel fließt, mittels dessen eine eine Verlustleistung bewirkende Umsetzeinrichtung gekühlt wird. Dieses Verfahren weist die Merkmale auf,
- dass eine Überwachungseinrichtung anhand von Betriebsdaten der Umsetzeinrichtung und/oder des Kühlmittelkreislaufes eine Fließgeschwindigkeit ermittelt, mit welcher das Kühlmittel in dem Kühlmittelkreislauf fließt,
- dass die Überwachungseinrichtung die ermittelte Fließgeschwindigkeit mit einer Grenzgeschwindigkeit vergleicht,
- dass die Überwachungseinrichtung eine Sonderreaktion ergreift, wenn die Fließgeschwindigkeit die Grenzgeschwindigkeit erreicht oder überschreitet, und
- dass die Überwachungseinrichtung entweder gar keine Reaktion ergreift oder eine von der Sonderaktion verschiedene Normalreaktion ergreift, solange die Fließgeschwindigkeit die Grenzgeschwindigkeit nicht erreicht.

Die Grenzgeschwindigkeit liegt in der Regel geringfügig unterhalb der vorbestimmten Geschwindigkeit, ab der die Gefahr einer Erosion oder Abrasion besteht. Beispielsweise kann die Grenzgeschwindigkeit bei einem hohen Prozentsatz (beispielsweise 95%, 98% oder 99%) der vorbestimmten Geschwindigkeit liegen oder einen vorbestimmten Abstand von der vorbestimmten Geschwindigkeit aufweisen (beispielsweise 2 cm/s, 5 cm/s oder 10 cm/s darunter liegen).

Im einfachsten Fall kann die Fließgeschwindigkeit des Kühlmittels mittels einer entsprechenden Messeinrichtung direkt gemessen werden. In einer bevorzugten Ausgestaltung der vorliegenden Erfindung sind der Überwachungseinrichtung jedoch eine mittels des Kühlmittels pro Zeiteinheit abzuführende Wärmemenge und eine lokale Temperatur der Umsetzeinrichtung bekannt und wird der Überwachungseinrichtung weiterhin als Messwert eine Vorlauftemperatur zugeführt, mit welcher das Kühlmittel der Umsetzeinrichtung zugeführt wird. In diesem Fall kann die Überwachungseinrichtung die Fließgeschwindigkeit anhand der pro Zeiteinheit abzuführenden Wärmemenge, der lokalen Temperatur der Umsetzeinrichtung und der Vorlauftemperatur ermitteln.

Prinzipiell ist eine direkte Ermittlung der Fließgeschwindigkeit möglich. Vorzugsweise ist jedoch vorgesehen, dass die Überwachungseinrichtung anhand der pro Zeiteinheit abzuführenden Wärmemenge, der lokalen Temperatur der Umsetzeinrichtung und der Vorlauftemperatur zunächst einen Wärmewiderstand des Kühlmittelkreislaufes ermittelt und sodann anhand des ermittelten Wärmewiderstandes die Fließgeschwindigkeit ermittelt. Den Wärmewiderstand kann die Überwachungseinrichtung dadurch ermitteln, dass sie die Differenz der lokalen Temperatur der Umsetzeinrichtung und der Vorlauftemperatur bildet und diese Temperatur durch die pro Zeiteinheit abzuführende Wärmemenge dividiert. Anhand des ermittelten Wärmewiderstands kann sodann die Fließgeschwindigkeit ermittelt werden. Die Fließgeschwindigkeit kann beispielsweise anhand einer Kennlinie ermittelt werden. Die Kennlinie - das heißt die Fließgeschwindigkeit als Funktion des Wärmewiderstands - kann beispielsweise rechnerisch anhand von Geometriedaten des Kühlmittelkreislaufes oder durch Versuche bestimmt werden.

Vorzugsweise ist die Überwachungseinrichtung mit einer Steuereinrichtung für die Umsetzeinrichtung verbunden. Alternativ kann die Überwachungseinrichtung mit der Steuereinrichtung eine Baueinheit bilden. Wiederum alternativ kann die Überwachungseinrichtung mit der Steuereinrichtung identisch sein. In allen drei Fällen ist es möglich, dass die Überwachungseinrichtung die abzuführende Wärmemenge und/oder die lokale Temperatur der Umsetzeinrichtung anhand des zeitlichen Verlaufs eines Ansteuerzustands ermittelt, mit dem die Steuereinrichtung die Umsetzeinrichtung ansteuert.

Alternativ ist es möglich, dass die Überwachungseinrichtung direkt Werte für die abzuführende Wärmemenge und/oder die lokale Temperatur der Umsetzeinrichtung entgegennimmt, beispielsweise entsprechende Messwerte.

Es ist möglich, dass die Grenzgeschwindigkeit fest vorgegeben ist. Alternativ ist es möglich, dass die Überwachungseinrichtung die Grenzgeschwindigkeit anhand einer Temperatur der Kühlflüssigkeit ermittelt.

Die Aufgabe wird weiterhin durch ein Computerprogramm für eine Überwachungseinrichtung eine Umsetzeinrichtung mit den Merkmalen des Anspruchs 7 gelöst. Erfindungsgemäß wird ein Computerprogramm der eingangs genannten Art derart ausgestaltet, dass die Abarbeitung des Maschinencodes durch die Überwachungseinrichtung bewirkt, dass die Überwachungseinrichtung ein erfindungsgemäßes Überwachungsverfahren ausführt.

Die Aufgabe wird weiterhin durch eine Überwachungseinrichtung mit den Merkmalen des Anspruchs 8 gelöst. Erfindungsgemäß ist die Überwachungseinrichtung mit einem erfindungsgemäßen Computerprogramm programmiert, so dass die Überwachungseinrichtung im Betrieb ein erfindungsgemäßes Überwachungsverfahren ausführt.

Die Aufgabe wird weiterhin durch eine Umsetzeinrichtung mit den Merkmalen des Anspruchs 9 gelöst. Eine vorteilhafte Ausgestaltung der erfindungsgemäßen Umsetzeinrichtung ist Gegenstand des abhängigen Anspruchs 10.

Erfindungsgemäß weist die Umsetzeinrichtung eine erfindungsgemäße Überwachungseinrichtung auf, die im Betrieb ein erfindungsgemäßes Überwachungsverfahren ausführt.

Vorzugsweise ist die Umsetzeinrichtung als Frequenzumrichter ausgebildet. Diese Anwendung stellt einen besonders häufigen und kritischen Anwendungsfall dar.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: eine Umsetzeinrichtung,
- FIG 2: ein Ablaufdiagramm,
- FIG 3: eine Kennlinie,
- FIG 4: eine weitere Umsetzeinrichtung und
- FIG 5: ein weiteres Ablaufdiagramm.

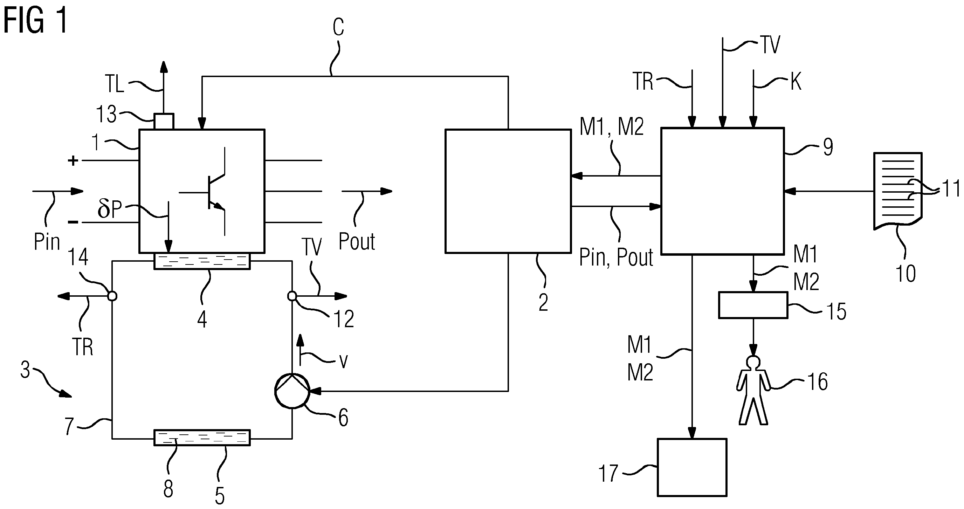

Gemäß FIG 1 wird mittels einer Umsetzeinrichtung 1 eine der Umsetzeinrichtung 1 zugeführte Eingangsleistung Pin in eine Ausgangsleistung Pout umgesetzt, die von der Umsetzeinrichtung 1 abgegeben wird. Die Ausgangsleistung Pout ist kleiner als die Eingangsleistung Pin. Die Differenz zwischen der Eingangsleistung Pin und der Ausgangsleistung Pout entspricht einer von der Umsetzeinrichtung 1 bewirkten Verlustleistung δP. Die Umsetzeinrichtung 1 ist entsprechend der Darstellung in FIG 1 als Frequenzumrichter ausgebildet. Mittels des Frequenzumrichters kann beispielsweise eine Gleichspannung (erkennbar an "+" und "-" eingangsseitig der Umsetzeinrichtung 1) in eine Wechselspannung (konkret in eine dreiphasige Wechselspannung, erkennbar an den drei Leitungen ausgangsseitig der Umsetzeinrichtung 1) umgesetzt werden. Es sind aber auch andere Ausgestaltungen der Umsetzeinrichtung 1 möglich. Insbesondere könnte der Frequenzumrichter auch in die umgekehrte Richtung arbeiten oder könnte die Umsetzeinrichtung 1 andersartig ausgebildet sein, beispielsweise als Verbrennungsmotor.

Die Umsetzeinrichtung 1 wird in vielen Fällen mittels einer Steuereinrichtung 2 gesteuert. In derartigen Fällen übermittelt die Steuereinrichtung 2 entsprechende Steuersignale C an die Umsetzeinrichtung 1. Die Steuersignale C bestimmen den jeweiligen Ansteuerzustand Z, mit dem die Steuereinrichtung 2 die Umsetzeinrichtung 1 ansteuert.

Die Umsetzeinrichtung 1 weist einen Kühlmittelkreislauf 3 auf. Der Kühlmittelkreislauf 3 umfasst in der Regel einen Kühlkörper 4, einen Wärmetauscher 5, eine Pumpe 6 sowie die zugehörigen Leitungen 7 zwischen dem Kühlkörper 4, dem Wärmetauscher 5 und der Pumpe 6. In dem Kühlmittelkreislauf 3 fließt ein Kühlmittel 8, mittels dessen die Umsetzeinrichtung 1 gekühlt wird. Das Kühlmittel 8 ist oftmals Wasser, dem bestimmte Zusätze beigefügt sein können. Mittels des Kühlkörpers 4 wird eine Wärmemenge aus der Umsetzeinrichtung 1 abgeführt. Die Wärmemenge korrespondiert im Wesentlichen mit der Verlustleistung δP. Nachfolgend wird daher die abzuführende Wärmemenge mit der Verlustleistung δP gleichgesetzt. Mittels des Wärmetauschers 5 wird die erforderliche Wärmemenge aus dem Kühlmittelkreislauf 3 abgeführt, beispielsweise an die Umgebung abgegeben. Die Pumpe 6 sorgt dafür, dass das Kühlmittel 8 in hinreichender Menge vom Kühlkörper 4 zum Wärmetauscher 5 und von dort wieder zum Kühlkörper 4 geführt wird. Die Pumpe 6 ist oftmals eine geregelte Pumpe. Falls dies der Fall ist, wird die Pumpe 6 von der Steuereinrichtung 2 gesteuert.

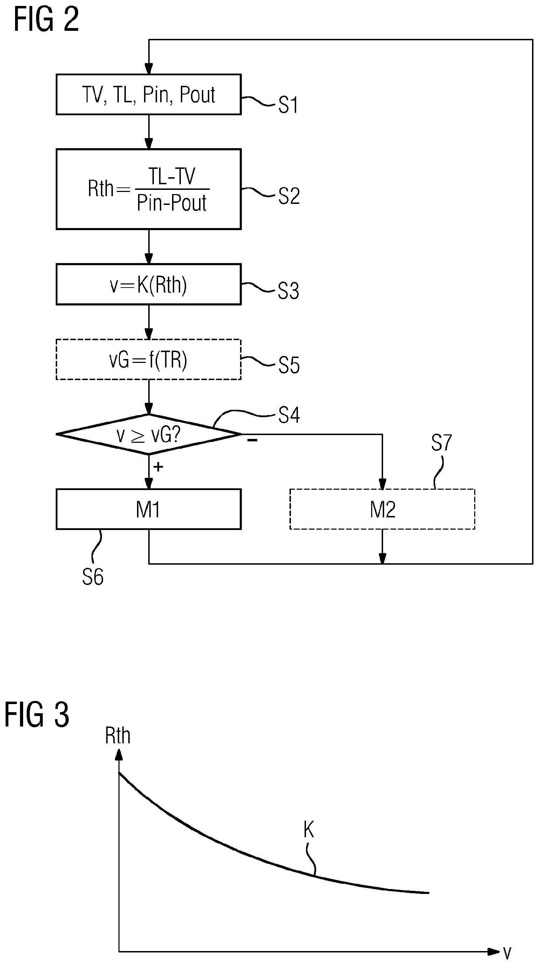

Die Umsetzeinrichtung 1 weist weiterhin eine Überwachungseinrichtung 9 auf. Die Überwachungseinrichtung 9 ist mit einem Computerprogramm 10 programmiert. Das Computerprogramm 10 umfasst Maschinencode 11, der von der Überwachungseinrichtung 9 unmittelbar abarbeitbar ist. Aufgrund der Programmierung der Überwachungseinrichtung 9 mit dem Computerprogramm 10 und der hiermit korrespondierenden Abarbeitung des Maschinencodes 11 durch die Überwachungseinrichtung 9 wird erreicht, dass die Überwachungseinrichtung 9 ein Überwachungsverfahren ausführt, das nachstehend in Verbindung mit FIG 2 näher erläutert wird.

Gemäß FIG 2 nimmt die Überwachungseinrichtung 9 in einem Schritt S1 Betriebsdaten der Umsetzeinrichtung 1 und/oder des Kühlmittelkreislaufes 3 entgegen.

Es ist möglich, dass die Betriebsdaten des Kühlmittelkreislaufes 3 direkt eine Fließgeschwindigkeit v umfassen, mit welcher das Kühlmittel 8 in dem Kühlmittelkreislauf 3 fließt. In diesem Fall entartet eine Ermittlung der Fließgeschwindigkeit v durch die Überwachungseinrichtung 9 zu einer einfachen Übernahme des vorgegebenen Wertes. Auch ist es möglich, den Druck eingangsseitig und ausgangsseitig der Pumpe 6 zu erfassen und aus der resultierenden Druckdifferenz in Verbindung mit der Drehzahl der Pumpe 6 den geförderten Volumenstrom zu ermitteln. Die entsprechende Vorgehensweise ist Fachleuten allgemein bekannt. Aus dem Volumenstrom kann über den Querschnitt des Kühlmittelkreislaufes 3 ohne weiteres die Fließgeschwindigkeit v ermittelt werden.

In der Regel wird die Fließgeschwindigkeit v jedoch weder direkt erfasst noch über die Druckdifferenz eingangsseitig und ausgangsseitig der Pumpe 6 und die Drehzahl der Pumpe 6 ermittelt. Vielmehr umfassen die Betriebsdaten in der Regel zumindest eine Vorlauftemperatur TV des Kühlmittelkreislaufes 3, das heißt diejenige Temperatur, mit welcher das Kühlmittel 8 dem Kühlkörper 4 zugeführt wird. Die Vorlauftemperatur TV wird in der Regel mittels eines entsprechenden Temperatursensors 12 messtechnisch erfasst. Die weiteren Betriebsdaten können nach Bedarf bestimmt sein. Im Ausführungsbeispiel gemäß den FIG 1 und 2 wird der Überwachungseinrichtung 9 als weiteres Betriebsdatum insbesondere eine lokale Temperatur TL der Umsetzeinrichtung 1 zugeführt. Die lokale Temperatur TL - bei einem Frequenzumrichter beispielsweise die Sperrschichttemperatur der Halbleiter - wird in der Regel mittels eines entsprechenden Temperatursensors 13 messtechnisch erfasst. Als weitere Betriebsdaten können der Überwachungseinrichtung 9 beispielsweise Messwerte oder rechnerisch ermittelte Werte für die Eingangsleistung Pin und die Ausgangsleistung Pout oder die Verlustleistung δP zugeführt werden.

In einem Schritt S2 kann die Überwachungseinrichtung 9 beispielsweise zunächst einen Wärmewiderstand Rth ermitteln. Die Überwachungseinrichtung 9 kann den Wärmewiderstand Rth entsprechend der Darstellung in FIG 2 insbesondere dadurch ermitteln, dass sie die Differenz der lokalen Temperatur TL und der Vorlauftemperatur TV bildet und diese Differenz durch die Differenz von Eingangsleistung Pin und Ausgangsleistung Pout, d.h. durch die Verlustleistung δP und damit im Kern die pro Zeiteinheit abzuführende Wärmemenge, dividiert. In einem Schritt S3 kann die Überwachungseinrichtung 9 sodann anhand des ermittelten Wärmewiderstandes Rth die Fließgeschwindigkeit v ermitteln.

Die Ermittlung der Fließgeschwindigkeit v anhand des ermittelten Wärmewiderstandes Rth kann beispielsweise entsprechend der Darstellung in FIG 3 anhand einer der Überwachungseinrichtung 9 bekannten Kennlinie K erfolgen, welche den funktionalen Verlauf der Fließgeschwindigkeit v als Funktion des Wärmewiderstands Rth (oder umgekehrt) wiedergibt. Die Kennlinie K kann beispielsweise anhand von Geometriedaten des Kühlmittelkreislaufes 3 oder aufgrund einer Messreihe ermittelt werden. Aus der Darstellung der Kennlinie K in FIG 3 ist insbesondere auch ersichtlich, dass der Wärmewiderstand Rth bei einem hohen Volumenstrom und damit einer hohen Fließgeschwindigkeit v gegen einen konstanten Wert strebt, während er bei kleineren Volumenströmen ansteigt.

In einem Schritt S4 vergleicht die Überwachungseinrichtung 9 die ermittelte Fließgeschwindigkeit v mit einer Grenzgeschwindigkeit vG.

Es ist möglich, dass die Grenzgeschwindigkeit vG der Überwachungseinrichtung 9 fest vorgegeben ist. Vorzugsweise aber ermittelt die Überwachungseinrichtung 9 die Grenzgeschwindigkeit vG in einem dem Schritt S4 vorgeordneten Schritt S5 die Grenzgeschwindigkeit vG. Die Überwachungseinrichtung 9 ermittelt in diesem Fall die Grenzgeschwindigkeit vG anhand einer Temperatur TR der Kühlflüssigkeit 8. Die Überwachungseinrichtung 9 verwertet im Rahmen der Ermittlung der Grenzgeschwindigkeit vG auch das Material des Kühlmittelkreislaufes 3 und die chemische Zusammensetzung des Kühlmittels 8. Diese Größen müssen der Überwachungseinrichtung 9 jedoch nur einmal vorgegeben werden, weil sie sich im Betrieb der Umsetzeinrichtung 1 und des Kühlmittelkreislaufes 3 nicht ändern.

Als Temperatur TR der Kühlflüssigkeit 8 wird vorzugsweise diejenige Temperatur verwendet, welche im Rücklauf des Kühlmittelkreislaufes 3 auftritt, also nachdem das Kühlmittel 8 den Kühlkörper 4 durchflossen hat. Die Temperatur TR wird, sofern sie verwertet wird, mittels eines entsprechenden Temperatursensors 14 erfasst. Der Schritt S5 ist, weil er nur optional vorhanden ist, in FIG 2 gestrichelt eingezeichnet. Es kann alternativ zwar auch die Vorlauftemperatur TV verwendet werden. Die Verwendung der Rücklauftemperatur TR ist jedoch vorzuziehen, weil die Rücklauftemperatur TR oberhalb der Vorlauftemperatur TV liegt und die Grenzgeschwindigkeit vG - sofern überhaupt eine Temperaturabhängigkeit der Grenzgeschwindigkeit vG besteht - in aller Regel bei höheren Temperaturen kleiner ist als bei niedrigeren Temperaturen.

Wenn die Überwachungseinrichtung 9 im Schritt S4 feststellt, dass die Fließgeschwindigkeit v die Grenzgeschwindigkeit vG erreicht oder überschreitet, geht die Überwachungseinrichtung 9 zu einem Schritt S6 über. Im Schritt S6 ergreift die Überwachungseinrichtung 9 eine Sonderreaktion. Beispielsweise kann sie eine Alarmmeldung M1 abgeben. Die Alarmmeldung M1 kann beispielsweise über eine Mensch-Maschine-Schnittstelle 15 an eine Bedienperson 16 ausgegeben werden. Alternativ oder zusätzlich ist eine Ausgabe an die Steuereinrichtung 2 möglich. In diesem Fall kann die Steuereinrichtung 2 beispielsweise eine Ansteuerung der Pumpe 6 anpassen, so dass die Fließgeschwindigkeit v reduziert wird. Soweit erforderlich, kann die Steuereinrichtung 2 zusätzlich die Ansteuerung der Umsetzeinrichtung 1 anpassen, so dass eine niedrigere Verlustleistung δP anfällt. Alternativ oder zusätzlich ist eine Ausgabe an eine andere Einrichtung 17 möglich, beispielsweise eine entfernte Rechnereinrichtung, die nicht in die Steuerung der Umsetzeinrichtung 1 und der Pumpe 6 eingebunden ist. Vom Schritt S6 aus geht die Überwachungseinrichtung 9 zum Schritt S1 zurück.

Wenn die Überwachungseinrichtung 9 im Schritt S4 hingegen feststellt, dass die Fließgeschwindigkeit v die Grenzgeschwindigkeit vG nicht erreicht, ist es möglich, dass die Überwachungseinrichtung 9 vom Schritt S4 aus direkt zum Schritt S1 zurückgeht. In diesem Fall ergreift die Überwachungseinrichtung 9 gar keine Reaktion. Beispielsweise wird die Alarmmeldung M1 nicht ausgegeben. Alternativ ist es möglich, dass die Überwachungseinrichtung 9 in dem Fall, dass die Fließgeschwindigkeit v die Grenzgeschwindigkeit vG nicht erreicht, zu einem Schritt S7 übergeht. Da der Schritt S7 nur optional vorhanden ist, ist er - analog zum Schritt S5 - in FIG 2 gestrichelt eingezeichnet.

Falls der Schritt S7 vorhanden ist, ergreift die Überwachungseinrichtung 9 im Schritt S7 eine Normalreaktion. Beispielsweise kann die Überwachungseinrichtung 9 eine OK-Meldung M2 abgeben. Die OK-Meldung M2 kann auf die gleiche Art und Weise wie die Alarmmeldung M1 an die Steuereinrichtung 2, über die Mensch-Maschine-Schnittstelle 15 an die Bedienperson 16 und/oder an die andere Einrichtung 17 ausgegeben werden.

Die Normalreaktion ist eine von der Sonderreaktion verschiedene Reaktion. Wenn beispielsweise das Ausgeben der Alarmmeldung M1 bewirkt, dass eine Signalleuchte der Mensch-Maschine-Schnittstelle 15 derart angesteuert wird, dass die Signalleuchte rot blinkt, kann das Ausgeben der OK-Meldung M2 darin bestehen, dass die Signalleuchte dauerhaft grün leuchtet. Es sind selbstverständlich auch andere Vorgehensweisen möglich.

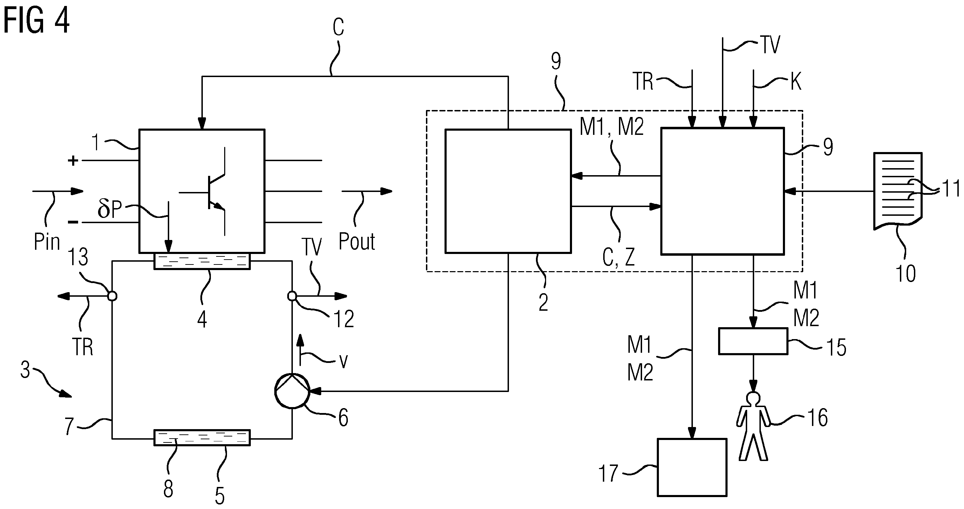

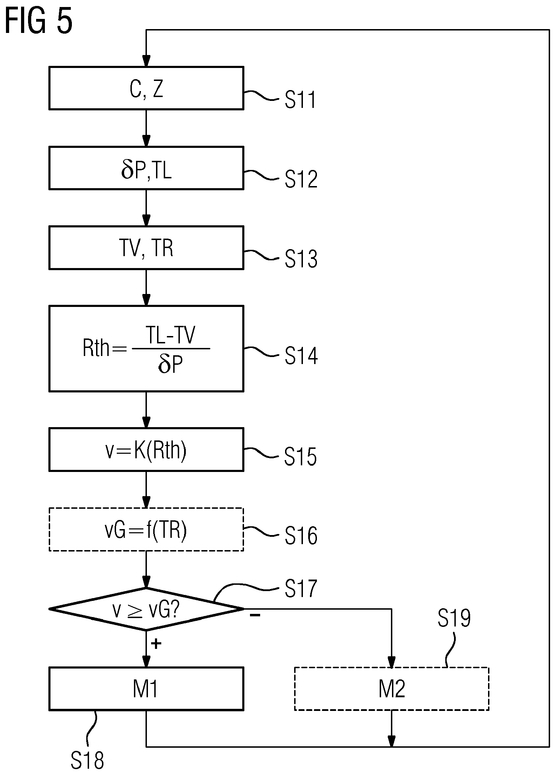

Nachstehend werden in Verbindung mit den FIG 4 und 5 eine weitere mögliche Ausgestaltung der Umsetzeinrichtung 1 und die hiermit korrespondierende Betriebsweise der Überwachungseinrichtung 9 erläutert.

In der Ausgestaltung gemäß FIG 4 ist, wie in FIG 4 durch eine gestrichelte Umrahmung angedeutet, eine der drei folgenden Möglichkeiten realisiert:
- die Überwachungseinrichtung 9 ist mit der Steuereinrichtung 2 verbunden oder
- die Überwachungseinrichtung 9 bildet mit der Steuereinrichtung 2 eine Baueinheit bildet oder
- die Überwachungseinrichtung 9 ist mit der Steuereinrichtung 2 identisch.

In diesen Fällen ist es möglich, dass die Steuereinrichtung 2 die ihr bekannten Daten an die Überwachungseinrichtung 9 übermittelt. Konkret übermittelt die Steuereinrichtung 2 in diesem Fall die Steuersignale C oder den hieraus resultierenden Ansteuerzustand Z an die Überwachungseinrichtung 9. Die Überwachungseinrichtung 9 nimmt die Steuersignale C bzw. den Ansteuerzustand Z gemäß FIG 5 in einem Schritt S11 entgegen.

In einem Schritt S12 ermittelt die Überwachungseinrichtung 9 in diesem Fall anhand der Steuersignale C oder des Ansteuerzustands Z die Verlustleistung δP (bzw. die abzuführende Wärmemenge) und/oder die lokale Temperatur TL der Umsetzeinrichtung 1. Soweit erforderlich, kann die Überwachungseinrichtung 9 in diesem Zusammenhang auch vorherige Steuersignale C bzw. Ansteuerzustände Z berücksichtigen, so dass sie die Verlustleistung δP (bzw. die abzuführende Wärmemenge) und/oder die lokale Temperatur TL der Umsetzeinrichtung 1 im Ergebnis anhand des zeitlichen Verlaufs des Ansteuerzustands Z ermittelt.

In einem Schritt S13 nimmt die Überwachungseinrichtung 9 - analog zum Schritt S1 von FIG 2 die Vorlauftemperatur TV (und gegebenenfalls auch die Rücklauftemperatur TR) entgegen.

An den Schritt S13 schließen sich Schritte S14 bis S19 an. Die Schritte S14 bis S19 korrespondieren 1:1 mit den Schritten S2 bis S7 von FIG 2. Es wird daher auf die entsprechenden Ausführungen zu den Schritten S2 bis S7 verwiesen.

Zusammengefasst betrifft die vorliegende Erfindung somit folgenden Sachverhalt:
Eine Umsetzeinrichtung 1, welche eine Eingangsleistung Pin in eine Ausgangsleistung Pout umsetzt und hierbei eine Verlustleistung δP bewirkt, wird mittels eines Kühlmittelkreislaufes 3 gekühlt, in dem ein Kühlmittel 8 fließt. Eine Überwachungseinrichtung 9 der Umsetzeinrichtung 1 ermittelt anhand von Betriebsdaten TV, TL, δP der Umsetzeinrichtung 1 und/oder des Kühlmittelkreislaufes 3 eine Fließgeschwindigkeit v, mit welcher das Kühlmittel 8 in dem Kühlmittelkreislauf 3 fließt. Die Überwachungseinrichtung 9 vergleicht die ermittelte Fließgeschwindigkeit v mit einer Grenzgeschwindigkeit vG. Wenn die Fließgeschwindigkeit v die Grenzgeschwindigkeit vG erreicht oder überschreitet, ergreift die Überwachungseinrichtung 9 eine Sonderreaktion. Solange die Fließgeschwindigkeit v die Grenzgeschwindigkeit vG nicht erreicht, ergreift die Überwachungseinrichtung 9 entweder gar keine Reaktion oder eine von der Sonderaktion verschiedene Normalreaktion.

Die vorliegende Erfindung weist viele Vorteile auf. Insbesondere kann online und nahezu in Echtzeit die aktuelle Fließgeschwindigkeit v ermittelt werden. Hierauf aufbauend können, soweit erforderlich, sicherheitsgerichtete Reaktionen ergriffen werden. Zur Erfassung der erforderlichen Messwerte können in der Regel bereits vorhandene Komponenten genutzt werden. Die Oxidschicht des Kühlmittelkreislaufes 3 kann geschützt und damit die Lebensdauer des Kühlmittelkreislaufes 3 deutlich gesteigert werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Überwachungsverfahren für einen Kühlmittelkreislauf (3), in dem ein Kühlmittel (8) fließt, mittels dessen eine eine Verlustleistung (δP) bewirkende Umsetzeinrichtung (1) gekühlt wird, **dadurch gekennzeichnet,**
- **dass** eine Überwachungseinrichtung (9) anhand von Betriebsdaten (TV, TL, δP) der Umsetzeinrichtung (1) und/oder des Kühlmittelkreislaufes (3) eine Fließgeschwindigkeit (v) ermittelt, mit welcher das Kühlmittel (8) in dem Kühlmittelkreislauf (3) fließt,
- **dass** die Überwachungseinrichtung (9) die ermittelte Fließgeschwindigkeit (v) mit einer Grenzgeschwindigkeit (vG) vergleicht,
- **dass** die Überwachungseinrichtung (9) eine Sonderreaktion ergreift, wenn die Fließgeschwindigkeit (v) die Grenzgeschwindigkeit (vG) erreicht oder überschreitet, und
- **dass** die Überwachungseinrichtung (9) entweder gar keine Reaktion ergreift oder eine von der Sonderaktion verschiedene Normalreaktion ergreift, solange die Fließgeschwindigkeit (v) die Grenzgeschwindigkeit (vG) nicht erreicht.

2. Überwachungsverfahren nach Anspruch 1,
**dadurch gekennzeichnet,**
**dass** der Überwachungseinrichtung (9) eine mittels des Kühlmittels (8) pro Zeiteinheit abzuführende Wärmemenge und eine lokale Temperatur (TL) der Umsetzeinrichtung (1) bekannt sind, dass der Überwachungseinrichtung (9) als Messwert eine Vorlauftemperatur (TV) zugeführt wird, mit welcher das Kühlmittel (8) der Umsetzeinrichtung (1) zugeführt wird, und dass die Überwachungseinrichtung (9) die Fließgeschwindigkeit (v) anhand der pro Zeiteinheit abzuführenden Wärmemenge, der lokalen Temperatur (TL) der Umsetzeinrichtung (1) und der Vorlauftemperatur (TV) ermittelt.

3. Überwachungsverfahren nach Anspruch 2,
**dadurch gekennzeichnet,**
**dass** die Überwachungseinrichtung (9) anhand der pro Zeiteinheit abzuführenden Wärmemenge, der lokalen Temperatur (TL) der Umsetzeinrichtung (1) und der Vorlauftemperatur (TV) zunächst einen Wärmewiderstand (Rth) des Kühlmittelkreislaufes (3) ermittelt und sodann anhand des ermittelten Wärmewiderstandes (Rth) die Fließgeschwindigkeit (v) ermittelt.

4. Überwachungsverfahren nach Anspruch 2 oder 3,
**dadurch gekennzeichnet,**
**dass** die Überwachungseinrichtung (9) mit einer Steuereinrichtung (2) für die Umsetzeinrichtung (1) verbunden ist oder dass die Überwachungseinrichtung (9) mit der Steuereinrichtung (1) eine Baueinheit bildet oder dass die Überwachungseinrichtung (9) mit der Steuereinrichtung (1) identisch ist und dass die Überwachungseinrichtung (9) die abzuführende Wärmemenge und/oder die lokale Temperatur (TL) der Umsetzeinrichtung (1) anhand des zeitlichen Verlaufs eines Ansteuerzustands (Z) ermittelt, mit dem die Steuereinrichtung (2) die Umsetzeinrichtung (1) ansteuert.

5. Überwachungsverfahren nach Anspruch 2 oder 3,
**dadurch gekennzeichnet,**
**dass** die Überwachungseinrichtung (9) Werte für die abzuführende Wärmemenge und/oder die lokale Temperatur (TL) der Umsetzeinrichtung (1) entgegennimmt.

6. Überwachungsverfahren nach einem der obigen Ansprüche,
**dadurch gekennzeichnet,**
**dass** die Überwachungseinrichtung (9) die Grenzgeschwindigkeit (vG) anhand einer Temperatur (TR) der Kühlflüssigkeit (8) ermittelt.

7. Computerprogramm für eine Überwachungseinrichtung (9) einer Umsetzeinrichtung (1), wobei das Computerprogramm Maschinencode (11) umfasst, der von der Überwachungseinrichtung (9) unmittelbar abarbeitbar ist, wobei die Abarbeitung des Maschinencodes (11) durch die Überwachungseinrichtung (9) bewirkt, dass die Überwachungseinrichtung (9) ein Überwachungsverfahren nach einem der obigen Ansprüche ausführt.

8. Überwachungseinrichtung einer Umsetzeinrichtung (1), wobei die Überwachungseinrichtung mit einem Computerprogramm (10) nach Anspruch 7 programmiert ist, so dass die Überwachungseinrichtung im Betrieb ein Überwachungsverfahren nach einem der Ansprüche 1 bis 6 ausführt.

9. Umsetzeinrichtung, mittels derer unter Bewirkung von Verlustleistung (δP) eine der Umsetzeinrichtung zugeführte Eingangsleistung (Pin) in eine Ausgangsleistung (Pout) umgesetzt wird, wobei die Umsetzeinrichtung einen Kühlmittelkreislauf (3) aufweist, in dem ein Kühlmittel (8) fließt, mittels dessen die Umsetzeinrichtung gekühlt wird, wobei die Umsetzeinrichtung eine Überwachungseinrichtung (9) nach Anspruch 8 aufweist, die im Betrieb ein Überwachungsverfahren nach einem der Ansprüche 1 bis 6 ausführt.

10. Umsetzeinrichtung nach Anspruch 9,
**dadurch gekennzeichnet,**
**dass** die Umsetzeinrichtung als Frequenzumrichter ausgebildet ist.
